# EUROPÄISCHE PATENTANMELDUNG

(11) **EP 0 563 679 A1**
(43) Veröffentlichungstag der Anmeldung: **06.10.1993**
(21) Anmeldenummer: 93104262.6
(22) Anmeldetag: 16.03.1993
(51) Int. Cl.: H01L 23/473

(54) **Einrichtung zum Kühlen von zu Flachbaugruppen zusammengefassten gehäuselosen integrierten Bausteinen**

(30) Priorität: 01.04.1992 DE 4210835
(71) Anmelder: Siemens Nixdorf Informationssysteme Aktiengesellschaft, D-33102 Paderborn (DE)
(72) Erfinder: Bachl, Johann, Dipl.-Ing., W-8000 München (DE)
(74) Vertreter: Fuchs, Franz-Josef, Dr.-Ing.

(57) **Zusammenfassung**

Die Erfindung bezieht sich auf eine Einrichtung zum Kühlen von zu Flachbaugruppen zusammengefaßten gehäuselosen filmmontierten integrierten Bausteinen (Mikropacks), deren Außenanschlüsse mit den zugehörigen Lötflecken einer Leiterplatte verbunden sind. Die Rückenflächen der Bausteine sind mit einer allen Bausteinen (3) gemeinsamen Kühlplatte (6) kontaktiert. Die Spider derartiger Bausteine wurden bisher Z-artig gebogen. Dafür ist aber wegen der geforderten Toleranzen ein hoher Arbeitsaufwand erforderlich. Die Erfindung sieht nun vor, diesen Arbeitsaufwand dadurch zu verringern, daß zwischen Baustein (3) und Kühlplatte (6) ein mit einer an den Rändern verdichtetes mit Metallfolie beschichtetes Metallplättchen (1) liegt, wobei in der Kühlplatte (6) und durch das Kühlplättchen (1) hindurch Absaugkanäle (2) vorgesehen sind, über die die Bausteine (3) durch Erzeugung eines Unterdrucks an das jeweilige Metallplättchen (1) angedrückt werden. Der Baustein (3) weist einen flachen Spider auf, der mit entsprechenden Lötflecken auf der Leiterplatte (7) kontaktiert ist. Dadurch wird eine gute Kühlung bei gleichzeitig einfacher Montage der Bausteine (3) erreicht.

## Beschreibung

Die Erfindung betrifft eine Einrichtung zum Kühlen von Zu Flachbaugruppen zusammengefaßten gehäuselosen filmmontierten integrierten Bausteinen (Mikropacks), deren Außenanschlüsse (Outerleads) mit den zugehörigen Lötflecken (Pads) einer Leiterplatte verbunden sind, wobei die Rückenflächen mit einer allen Bausteinen gemeinsamen ebenen mit Kühlkanälen zur Aufnahme eines Kühlmediums versehenen Kühlplatte kontaktiert sind.

Aus der europäischen Patentschrift 0 103 068 B1 ist eine Einrichtung zum Kühlen einer Mehrzahl von Zu Flachbaugruppen zusammengefaßten integrierten Bausteinen bekannt, bei der hochintegrierte Bausteine über einen Z-förmigen Spider mit der Leiterplatte verbunden sind. Dabei wird der Bauteilekörper auf den Spider aufgelötet (Innerleadbonding) und dann wird der Spider freigeschnitten und Z-förmig gebogen. Der so entstandene Mikropack wird mit den Außenanschlüssen (Outerleads) auf die Leiterplatte aufgelötet. Zwischen Baustein und Leiterplatte sitzen Druckstücke, die Toleranzunterschiede ausgleichen und den Andruck des Bausteins an die Kühlplatte gewährleisten, um die Verlustleistung abzuführen. Per Spider ist in Z-Richtung gebogen und muß Wegunterschiede in Z-Richtung ausgleichen, die durch Zusammendrücken des Druckstückes und durch die Biegung der Leiterplatte entstehen. Dies kann zu höheren Ungenauigkeiten am Spider führen.

Aufgabe der vorliegenden Erfindung ist es, eine Einrichtung zum Kühlen von zu Flachbaugruppen Zusammengefaßten integrierten Bausteinen zu schaffen, die eine vereinfachte Herstellung von Mikropacks sowie eine vereinfachte Montage derselben auf Leiterplatten ermöglicht.

Zur Lösung dieser Aufgabe wird die Einrichtung zum Kühlen von zu Flachbaugruppen Zusammengefaßten gehäuselosen Baustelnen derart ausgebildet, daß Zwischen Baustein und Kühlplatte ein mit einer an den Rändern verdichteten Metallfolie beschichtetes Metallplättchen liegt, daß in der Kühlplatte und durch das Kühlplättchen hindurch ein Absaugkanal vorgesehen ist, über den der Baustein durch Erzeugung eines Unterdrucks auf das Metallplättchen angedrückt wird und daß der Baustein einen flachen Spider aufweist, der mit entsprechenden Lötflecken auf der Leiterplatte kontaktiert ist.

Durch diese Maßnahmen werden die durch den Biegevorgang des Spiders bei herkömmlichen Mikropacks häufig auftretenden Ungenauigkeiten zwischen der Deckungsgleichheit seiner Außenanschlüsse mit den jeweils zugeordneten Pads der Leiterplatte, die nur durch aufwendige zusätzliche Maßnahmen verhindert werden können, vermieden.

Zum Temperaturausgleich zwischen Kühlplatte und Baustein können die Außenanschlüsse des Bausteins entweder mit einer Sicke in Z-Richtung versehen sein, oder mit Auslenkungen in der XY-Ebene.

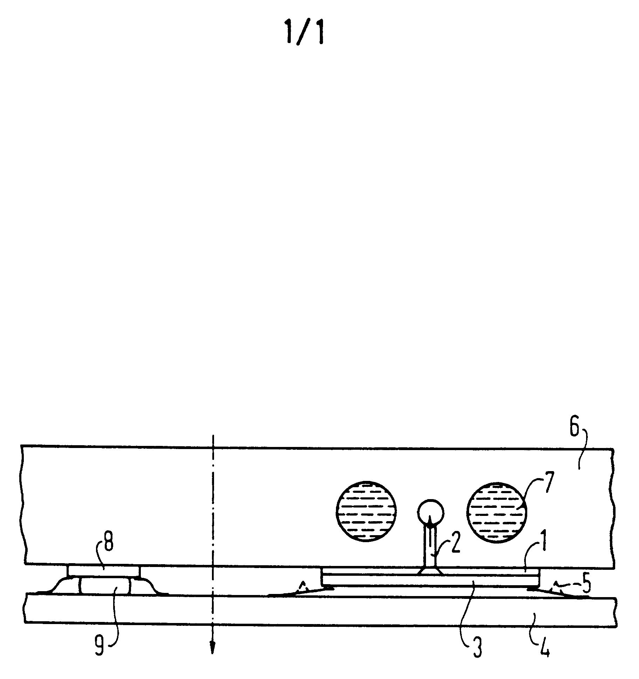

Anhand des Ausführungsbeispiels nach der Figur wird die Erfindung näher erläutert.

Der als Mikropack ausgeführte LSI-Baustein 3 wird mit flachem Spider mit den Pads der Leiterplatte verlötet. Die Kühlplatte 6 an den Rückseiten der Bausteine 3 enthält kühlmitteldurchflossene Kühlkanäle 7. Zwischen der Bausteinrückseite und der Kühlplatte 6 liegt außerdem ein Metallplättchen 1, das zum Höhenausgleich dient, wenn weitere kleinere Bausteine, z.B. MSI's in herkömmlicher Form mit Zwischenstücken 9 ebenfalls auf der Leiterplatte 7 montiert sind. In der Kühlplatte 6 und durch das Kühlplättchen 1 hindurch ist für jeden Mikropack ein Absaugkanal 2 vorgesehen. Durch Erzeugen eines Unterdrucks wird der zwischen Kühlplatte und Leiterplatte 7 montierte Baustein 3 an das mit Metallfolie beschichtete Metallplättchen 1 angesaugt und somit ein guter Wärmekontakt hergestellt. Die Metallfolie 1 muß an den Rändern etwas dicker aufgebracht werden, um mit den Bausteinrand abzudichten.

## Patentansprüche

1. Einrichtung zum Kühlen von zu Flachbaugruppen zusammengefaßten gehäuselosen filmmontierten integrierten Bausteinen (Mikropacks), deren Außenanschlüsse (Outerleads) mit den zugehörigen Lötflecken (Pads) einer Leiterplatte verbunden sind, wobei die Rückenflächen mit einer allen Bausteinen gemeinsamen ebenen mit Kühlkanälen zur Aufnahme eines Kühlmediums versehenen Kühlplatte kontaktiert sind, **dadurch gekennzeichnet,** daß zwischen Baustein (3) und Kühlplatte (6) ein mit einer an den Rändern verdichteten Metallfolie beschichtetes Metallplättchen (1) liegt, daß in der Kühlplatte (6) und durch das Kühlplättchen (1) hindurch ein Absaugkanal (2) vorgesehen ist, über den der Baustein (3) durch Erzeugung eines Unterdrucks auf das Metallplättchen (1) angedrückt wird und daß der Baustein (3) einen flachen Spider (4) aufweist, der mit entsprechenden Lötflecken auf der Leiterplatte (7) kontaktiert ist.

2. Einrichtung zum Kühlen von zu Flachbaugruppen zusammengefaßten gehäuselosen filmmontierten integrierten Bausteinen (Mikropacks) nach Anspruch 1, **dadurch gekennzeichnet,** daß der Spider (4) in vertikaler Richtung eine Sicke aufweist.

3. Einrichtung zum Kühlen von zu Flachbaugruppen zusammengefaßten gehäuselosen filmmontierten integrierten Bausteinen (Mikrpacks) nach Anspruch 1, **dadurch gekennzeichnet,** daß der Spider (4) in der Leiterplattenebene eine Auslenkung aufweist.
